Europäisches Patentamt

European Patent Office

Office européen des brevets

(19)

(11) Publication number: **0 020 144**
**B1**

(12) # EUROPEAN PATENT SPECIFICATION

(45) Date of publication of patent specification: **29.01.86**

(51) Int. Cl.⁴: **H 01 L 21/76**

(21) Application number: **80301781.3**

(22) Date of filing: **29.05.80**

(54) **Method of producing a semiconductor device.**

(30) Priority: **31.05.79 JP 67611/79**
**31.05.79 JP 67612/79**
**31.05.79 JP 67614/79**

(43) Date of publication of application:
**10.12.80 Bulletin 80/25**

(45) Publication of the grant of the patent:
**29.01.86 Bulletin 86/05**

(84) Designated Contracting States:
**DE FR GB NL**

(56) References cited:
**DE-A-2 361 319**
**FR-A-2 350 937**
**FR-A-2 447 095**
**US-A-4 046 606**
**US-A-4 089 103**

**IBM TECHNICAL DISCLOSURE BULLETIN, vol.
18, no. 2, July 1975, pages 380-381, New York,
USA, A.W. CHANG et al.: "Diffused trench
isolation with P channels"**

(73) Proprietor: **FUJITSU LIMITED**
**1015, Kamikodanaka Nakahara-ku
Kawasaki-shi Kanagawa 211 (JP)**

(72) Inventor: **Hataishi, Osamu**
**4-215, Sakuradai Midori-ku
Yokohama-shi Kanagawa 227 (JP)**
Inventor: **Momma, Yoshinobu**
**1882-18, Shindo
Sagamihara-shi Kanagawa 228 (JP)**
Inventor: **Abe, Ryoji**
**5-5-104, Shin-isono 4-chome
Sagamihara-shi Kanagawa 228 (JP)**

(74) Representative: **Allman, Peter John et al
Marks and Clerk Scottish Life House
Bridge Street
Manchester M3 3DP (GB)**

Courier Press, Leamington Spa, England.

## Description

### Background of the Invention
*Field of the Invention*

The present invention relates to a method for producing a semiconductor device comprising at least one semiconductor element and an isolation region which are formed in an epitaxial layer formed on a semiconductor substrate. More particularly, the present invention relates to a method for forming both a silicon oxide layer which lies on and around the semiconductor element, and an isolation region which lies around the semiconductor element and has an opposite conductivity type to that of the epitaxial layer.

*Description of the Prior Art*

In a case where a semiconductor integrated circuit is produced by forming semiconductor elements, such as transistors, and passive elements, such as diffused transistors, in an epitaxial layer formed on a silicon semiconductor substrate, generally, after a silicon oxide layer is formed as a protecting layer on the surface of the integrated circuit, connecting lines of a conductor, such as aluminum, are formed on the silicon oxide layer. In this case, in order to decrease the parasitic capacity between the epitaxial layer and the aluminum connecting lines, the above-mentioned silicon oxide layer is made thick. Furthermore, in order to prevent a so-called parasitic effect from occurring between the semiconductor elements, an isolation region between the semiconductor elements is formed by introducing impurities having an opposite conductivity type to that of the epitaxial layer into a predetermined portion of the epitaxial layer.

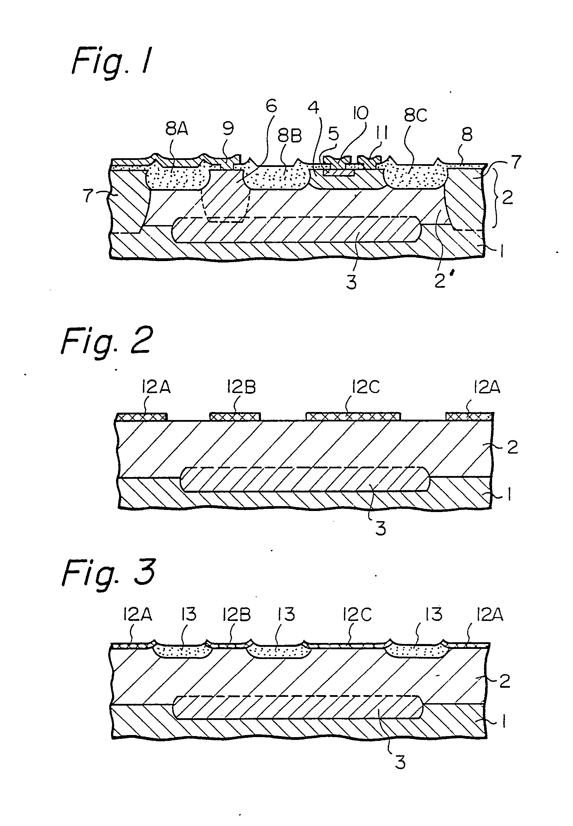

A semiconductor element (e.g. an npn-type bipolar transistor) of an integrated circuit is illustrated in the schematic sectional view of Fig. 1. Such bipolar transistor is illustrated in Fig. 2 of United States Patent No. 3,911,471. In Fig. 1, reference numerals 1, 2, 2' and 3 indicate a p-type silicon substrate, an n-type silicon epitaxial layer, an isolated region and an n-type buried layer, respectively. The electrical resistance of the epitaxial layer 2 is high and, consequently, the breakdown voltage between the collector and the base of the bipolar transistor is high. The buried layer 3 can reduce the series resistance of the collector. Reference numerals 4, 5, 6 and 7 indicate a p-type base region, an n-type emitter region, an n-type collector connecting region and an isolation region, respectively. These regions 4, 5, 6 and 7 are formed in the epitaxial layer 2. Since the isolation region 7 has the opposite conductivity type to that of the epitaxial layer and surrounds the isolated region 2', it is possible to electrically isolate the bipolar transistor from other transistors and passive elements (not shown). Reference numerals 8, 8A through 8C, 9, 10 and 11 indicate a silicon oxide layer, thick portions of the silicon oxide layer, a collector electrode, an emitter electrode and base electrode, respectively. The thick portions 8A, 8B and 8C of the silicon oxide layer 8 decrease the parasitic capacitance between the epitaxial layer and the connecting lines of the electrodes 9, 10 and 11. According to Fig. 1 the thick portions of the silicon oxide layer are separated, but the thick portions combine at a place not shown in Fig. 1.

The bipolar transistor illustrated in Fig. 1 is produced in the following manner. Referring to Fig. 2, the starting material is a p-type silicon semiconductor substrate 1. N-type impurities are introduced into a predetermined portion of the silicon substrate 1 by ion-implantation or thermal diffusion to form a buried layer 3. An n-type silicon epitaxial layer 2 is formed on the silicon substrate 1 by epitaxial growth and, at the same time, some impurities diffuse out of the buried layer 3 into the epitaxial layer 2, so that the buried layer 3 expands up to a broken line in Fig. 2. A silicon nitride layer serving as an anti-oxidation masking layer is formed on the epitaxial layer 2 by chemical vapor deposition and, then, is selectively removed by photoetching, so that portions 12A, 12B and 12C of the silicon nitride layer remain, as illustrated in Fig. 2. If desired, a thin oxide layer may be provided under the silicon nitride layer.

Next, the semiconductor body comprising the silicon substrate 1 and the silicon epitaxial layer 2 is thermally oxidized at 1000°C for approximately 2 hours. Since the silicon nitride layer portions 12A, 12B and 12C serve as an anti-oxidation mask during the oxidation period, a silicon dioxide (SiO$_2$) layer 13 having a thickness of approximately 700 nm is formed, as illustrated in Fig. 3.

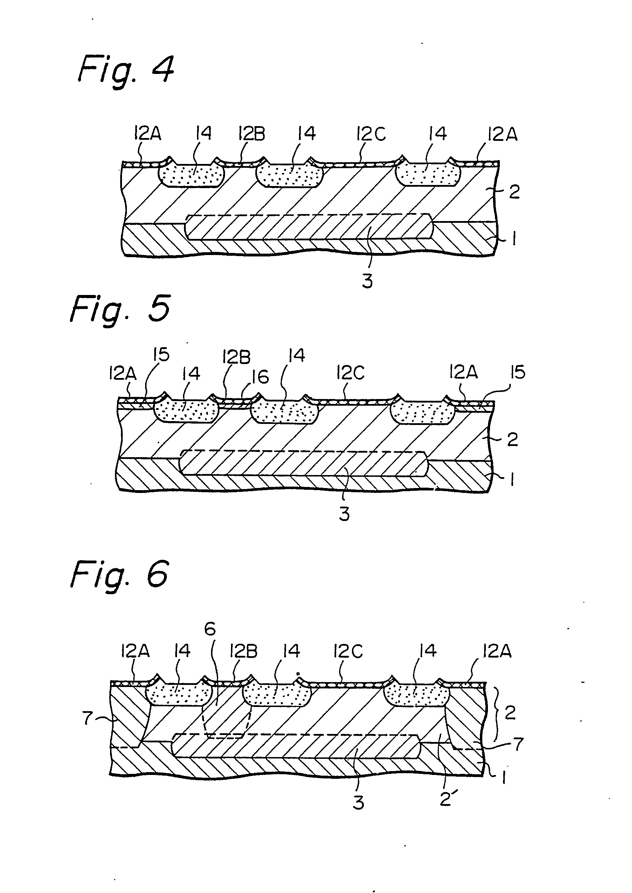

The formed silicon dioxide layer 13 is removed by etching to expose a portion of the epitaxial layer 2. Then, the semiconductor body is also thermally oxidized at 1000°C for approximately 8 hours to form a thick silicon dioxide layer 14 having a thickness of approximately 1.4 μm, as illustrated in Fig. 4.

Next, a photo resist layer (not shown) is applied on the entire surface and, then, a portion of the resist layer which lies on the silicon nitride layer portion 12A is removed. P-type impurities are introduced through the silicon nitride layer portion 12A into the epitaxial layer 2 by ion-implantation to form a high concentration region 15 of p-type impurities, as illustrated in Fig. 5. After the applied resist layer is removed, another photo resist layer is applied onto the entire surface, and then, a portion of the resist layer which lies on the silicon nitride layer portion 12B is removed. N-type impurities are introduced through the silicon nitride layer portion 12B into a portion of the epitaxial layer 2 by ion-implantation to form a high concentration region 16 of n-type impurities, as illustrated in Fig. 5.

The obtained semiconductor body is heated at 1100°C for approximately 1 hour, whereby the p-type impurities in the high concentration regions 15 diffuse into the epitaxial layer 2 and arrive at the silicon substrate 1 to form an isolation region 7 for isolating semiconductor elements from each other and, at the same time, the n-type impurities in the high concentration region 16 diffuse and arrive at the buried layer 3 to form a collector connecting region 6, as illustrated in Fig. 6.

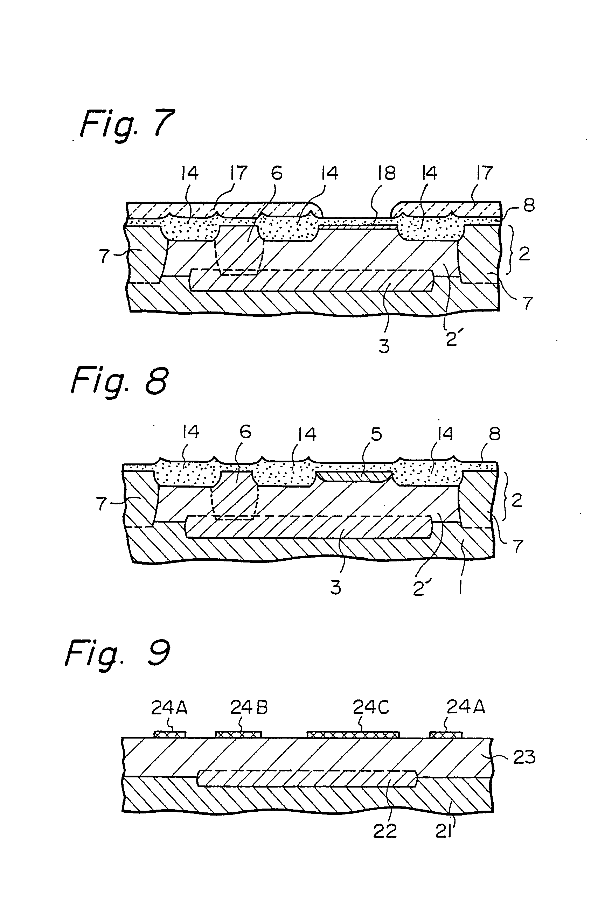

Next, the remaining silicon nitride layer portions 12A, 12B and 12C are removed to expose portions of the epitaxial layer 2. The obtained semiconductor body is thermally oxidized at 900°C for approximately 30 minutes to form a thin silicon dioxide layer 8, having a thickness of approximately 50 nm, on the surfaces of the exposed portions the epitaxial layer 2 including the isolation region 7 and the collector connecting region 6, as illustrated in Fig. 7. A patterned photo resist layer 17 is formed on the thin and thick silicon dioxide layers 8 and 14, as illustrated in Fig. 7. P-type impurities are introduced through a portion of the thin silicon dioxide layer 8 into a portion of the isolated region 2' of the epitaxial layer 2 by ion-implantation to form a high concentration region 18 of the p-type impurities.

The obtained semiconductor body is annealed by heating at 1000°C for approximately 10 minutes, whereby the impurities in the high concentration region 18 diffuse to a predetermined depth in the epitaxial layer 2, so that a base region 5 is formed, as illustrated in Fig. 8. Then, N-type impurities are introduced into a portion of the base region 5 by ion-implantation subsequent to etching of a portion of the thin silicon dioxide layer lying on the base region 5 by photoetching. An annealing treatment is carried out at 1000°C for approximately 20 minutes to form an emitter region 4, as illustrated in Fig. 1.

Openings for the collector electrode 9 and for the base electrode 11 are formed in the thin silicon dioxide layer above the collector connecting region 6 and the base region 5, respectively, by photoetching, as illustrated in Fig. 1. Finally, a conductor layer of aluminum is formed on the entire surface by vapour deposition and, then, is selectively removed by photoetching to form the collector, base and emitter electrodes 9, 11 and 10, respectively. In the above described manner, an npn-type bipolar transistor isolated from other elements is produced, as illustrated in Fig. 1.

However, when the thick silicon dioxide layer 14 (Fig. 4) is formed prior to the introduction of impurities into the epitaxial layer 2, a portion of the epitaxial layer lying under the silicon nitride layer portions 12A, 12B and 12C is oxidized into silicon dioxide. Namely, a portion of the thick silicon dioxide layer 14 enters under the silicon nitride layer portions to form a so-called bird's beak, as illustrated in Fig. 4. Since the bird's beak of silicon dioxide prevents the impurities from entering into the epitaxial layer 2, for example, in order to form the isolation region 7 having a width of 1 μm, it is necessary to make the width of the silicon nitride layer portion 12A approximately 3 μm. As the width of the silicon nitride layer portion 12A increases, on the one hand, its area increases, and on the other hand, the area for semiconductor elements and passive elements of the integrated circuit decreases. Therefore, it is difficult to increase the degree of integration of the semiconductor elements and the passive elements in the integrated circuit.

Furthermore, according to the above-mentioned production method, the method comprises the step of forming the thick silicon dioxide layer, and the step of diffusing the impurities for forming the isolation region and the collector connecting region, namely, a heat-treatment is carried out at least two times. When the heat-treatment is repeated, the impurities in the buried layer diffuse upward in the epitaxial layer. As the result of this, the breakdown voltage between the collector and the emitter decreases.

Summary of the Invention

It is an object of the present invention is to increase the degree of integration of semiconductor elements and passive elements in an integrated circuit over that of the prior art and to prevent the breakdown voltage between the collector and the base of a bipolar transistor from decreasing, by providing an improved method for producing a semiconductor device comprising at least one semiconductor element and an isolation region which are formed in an epitaxial layer formed on a semiconductor substrate.

The present invention is based on recognition of the fact that, where impurities are introduced into the epitaxial layer prior to the step of forming a thick oxide layer by thermal oxidation, an integrated circuit design (i.e. the shapes and dimensions of the semiconductor elements, the passive elements and the isolation region) can be determined without taking the formation of a bird's beak of the thick oxide layer into consideration, and that the formation of the thick oxide layer and the formation of the isolation region can be carried out in one heat-treatment.

According to the present invention, there is provided a method of producing a semiconductor device comprising at least one semiconductor element and an isolation region which are formed in an epitaxial layer formed on a semiconductor substrate having a buried layer, said method comprising, the steps of forming a mask pattern for preventing impurities from entering portions of said epitaxial layer covered by the mask pattern, introducing impurities into predetermined portions of said epitaxial layer not covered by the mask pattern, forming a patterned anti-oxidation masking layer for selective thermaloxidation of the epitaxial layer, and thermally oxidizing portions of said epitaxial layer not covered by the masking layer to form a thick oxide layer at the same time said introduced impurities are diffused into said epitaxial layer to form said isolation region.

Brief Description of the Drawings

Fig. 1 is a schematic sectional view of a bipolar transistor of an integrated circuit;

Figs. 2 through 8 are schematic sectional views of the bipolar transistor of Fig. 1 in intermediate stages of production in accordance with prior art techniques;

Figs. 9 through 13 are schematic sectional views of a bipolar transistor in intermediate stages of production in accordance with an embodiment A of the present invention;

Figs. 14 and 15 are schematic sectional views of a bipolar transistor in intermediate stages of production in accordance with an embodiment B of the present invention;

Figs. 16 and 17 are schematic sectional views of a bipolar transistor in intermediate stages of production in accordance with the embodiment C of the present invention;

Figs. 18 and 19 are schematic sectional views of a bipolar transistor in intermediate stages of production in accordance with an embodiment D of the present invention;

Figs. 20 through 22 are schematic sectional views of a bipolar transistor in intermediate stages of production in accordance with combinations of the embodiments;

Fig. 23 is a schematic sectional view of a bipolar transistor in an intermediate stage of production in accordance with a variant combination of the embodiments;

Figs. 24 through 31 are schematic sectional views of a bipolar transistor in intermediate stages of production in accordance with an embodiment E;

Figs. 32 and 33 are schematic sectional views of a bipolar transistor in intermediate stages of. production in accordance with an embodiment F;

Figs. 34 and 35 are schematic sectional views of a bipolar transistor in intermediate stages of production in accordance with an embodiment G;

Figs. 36 through 42 are schematic sectional views of a bipolar transistor in accordance with an embodiment H, and;

Fig. 43 is a schematic sectional view of a bipolar transistor in an intermediate stage of production in accordance with an embodiment I.

Description of the Preferred Embodiments

A first preferable embodiment according to the present invention of a method of producing a semiconductor device comprising at least one semiconductor element and an isolation region, which are formed in an epitaxial layer formed on a semiconductor substrate having a buried layer, comprises the steps of:

forming an anti-oxidation masking layer on the epitaxial layer;

selectively removing the masking layer by photoetching to expose portions of the epitaxial layer;

thermal-oxidizing the exposed portions of the epitaxial layer to form a thin oxide layer;

forming a patterned resist layer;

introducing impurities into a predetermined portion of the epitaxial layer which is covered by the masking layer and is not under the resist layer;

removing the patterned resist layer, and;

thermal-oxidizing the epitaxial layer by using the remaining anti-oxidation masking layer as a mask to form a thick oxide layer.

The above-mentioned first embodiment will now be explained in detail by the following embodiments A through D with reference to the drawings.

*Embodiment A*

Referring to Fig. 9, the starting material is a p-type silicon semiconductor substrate 21. N-type impurities (e.g. antimony) are introduced into a predetermined portion of the silicon substrate 21 to form an $n^+$-type buried layer 22. An n-type silicon epitaxial layer 23, having a high resistance, is formed on the silicon substrate 21 and, at the same time, some n-type impurities diffuse out of the buried layer 22 into the epitaxial layer 23, so that the buried layer 22 expands up to a broken line in Fig. 9. A silicon nitride layer having a thickness of approximately 50 nm and serving as an anti-oxidation masking layer is formed on the epitaxial layer 23 by chemical vapor deposition, and then, is selectively removed by photoetching so that portions 24A, 24B and 24C of the silicon nitride layer remain, as illustrated in Fig. 9.

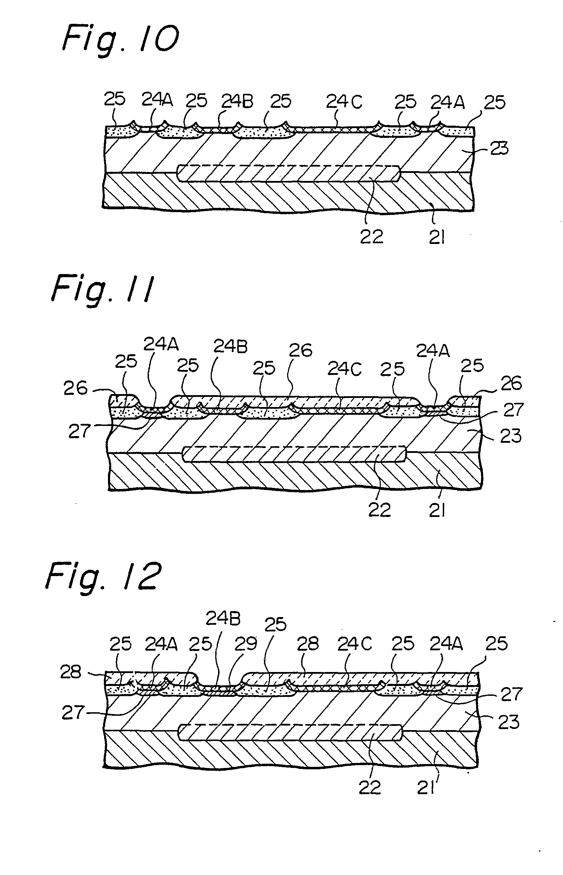

Next, the semiconductor body comprising the silicon substrate 21 and the epitaxial layer 23 is heated at 1000°C, for approximately 2 hours, in an oxidizing atmosphere. As the result, the portion of the epitaxial layer 23 which is not covered by the silicon nitride layer portions 24A, 24B and 24C is oxidized to form a thin silicon dioxide layer 25 having a thickness of approximately 700 nm, as illustrated in Fig. 10.

A photo resist layer 26 is applied on the entire surfaces of the silicon nitride layer portions 24A, 24B and 24C, and the thin silicon dioxide layer 25, and then, is selectively etched to remove a portion of it which lies on the silicon nitride layer portion 24A, as illustrated in Fig. 11. P-type impurities (e.g. boron) are introduced through the silicon nitride layer portion 24A into the epitaxial layer 23 by ion-implantation to form a high concentration region 27 (Fig. 11) of p-type impurities.

After the photo resist layer 26 is removed, another photo resist layer 28 is applied onto the entire surfaces of the layer portions 24A, 24B and 24C, and the layer 25, and then, is selectively etched to remove a portion of it which lies on the silicon nitride layer portion 24B, as illustrated in Fig. 12. N-type impurities (e.g. phosphorus) are introduced through the silicon nitride layer 24B into the epitaxial layer 23 by ion-implantation to form a high concentration region 29 (Fig. 12) of N-type impurities. The photo resist layer 28 is then removed.

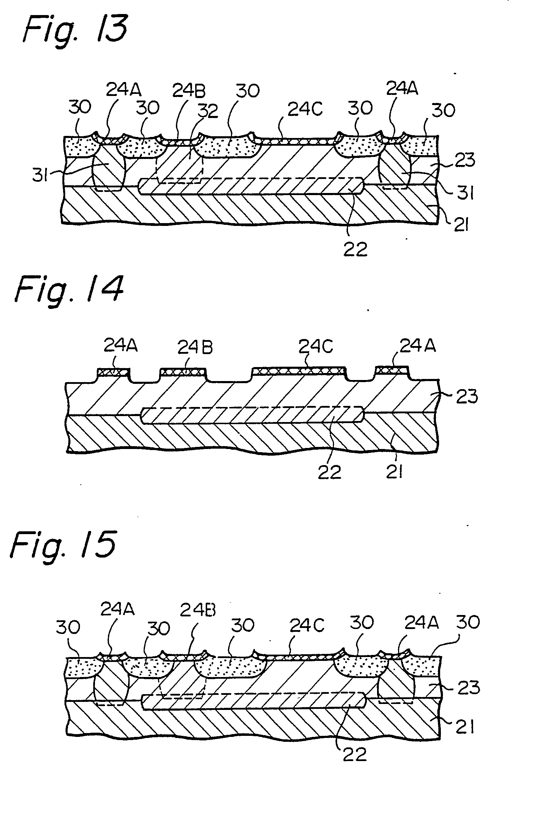

Next, the obtained semiconductor body is heated at 1000°C, for approximately 6 hours, in the oxidizing atmosphere. As a result of the heat-treatment, i.e. a thermal oxidation treatment, the thickness of the thin silicon dioxide layer 25 increases to form a thick silicon dioxide layer 30 having a thickness of approximately 1.4 µm, the p-type impurities in the high concentration region 27 diffuse into the epitaxial layer 23 and arrive at the silicon substrate 21 to form an isolation region 31 and, simultaneously, the n-type impurities in the high concentration region 29 diffuse and arrive at the buried layer 22 to form a collector connecting region 32, as illustrated in Fig. 13.

Thus, since the formation of the thick silicon dioxide layer, the isolation region and the collector connecting region are simultaneously carried out, the number of heat-treatments is decreased as compared with the above-mentioned prior art method of producing a semiconductor device. Therefore, the decrease in the breakdown voltage between the collector and the base caused by diffusing the n-type impurities out of the buried layer into the epitaxial layer is smaller than in the prior art.

In order to complete a bipolar transistor, a base region, an emitter region, a collector electrode, a base electrode, an emitter electrode and a required thin silicon dioxide layer are formed in the same manner as in the above-mentioned prior art method.

### Embodiment B

Prior to the step of forming the thin silicon dioxide layer 25 (Fig. 10) of the embodiment A of the present invention, a portion of the epitaxial layer 23 can be etched by an etchant (e.g. $HF:HNO_3:AgNO_3 = 5:40:1$), as illustrated in Fig. 14. In this case, the silicon nitride layer portions 24A, 24B and 24C serve as a mask, and the etching depth is approximately 300 nm. Furthermore, the etching of the epitaxial layer can be carried out by a plasma etching process. In this case, a photo resist layer (not shown) is applied onto the silicon nitride layer subsequent to formation of the silicon nitride layer and, then, is exposed and developed. Since all of the silicon nitride layer, except for its portions 24A, 24B and 24C, is exposed, the exposed portion of the silicon nitride layer and the portion of the epitaxial layer thereunder can be etched by plasma. Then, the obtained semiconductor body is treated in the same manner as in method of the embodiment A to obtain the semiconductor body in the state illustrated in Fig. 15.

The difference between the levels of the surface of the thick silicon dioxide layer 30 (Fig. 15) and the surface of the epitaxial layer 23 (Fig. 15) is smaller as compared with that of the semiconductor body in the state illustrated in Fig. 13, in case of the embodiment A.

### Embodiment C

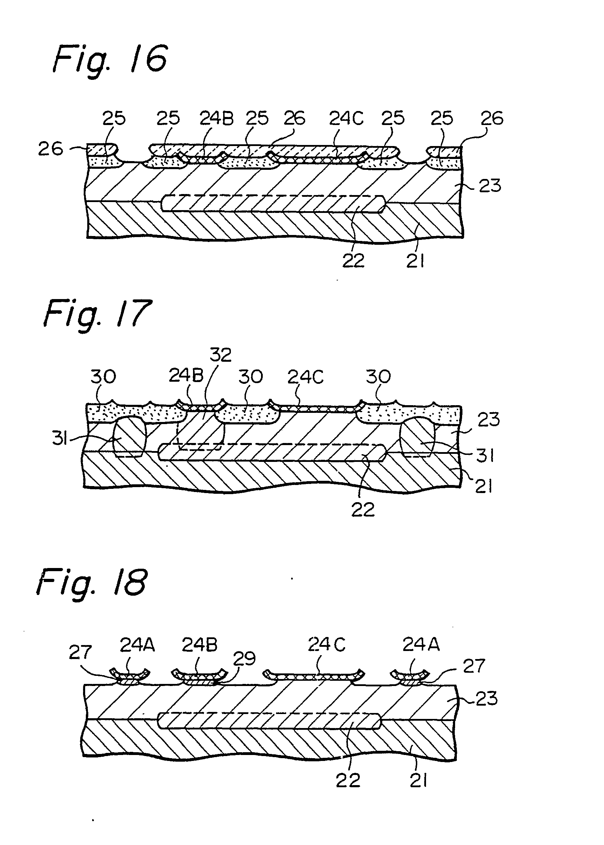

Subsequent to the step of forming the photo resist layer 26 (Fig. 11) and prior to the step of introducing the impurities of the embodiment A, the silicon nitride layer portion 24A can be etched by as illustrated in Fig. 16. Therefore, the p-type impurities can be directly introduced into an exposed portion of the epitaxial layer 23. The procedure for producing a semiconductor device in this embodiment, except for the above-mentioned etching step is same as that of the embodiment A. As the result, the semiconductor body in the state illustrated in Fig. 17 is obtained. A portion of the thick silicon dioxide layer 30 is formed on the isolation region 31, whereby the parasitic capacitance between a connecting line and the isolation region can be decreased.

### Embodiment D

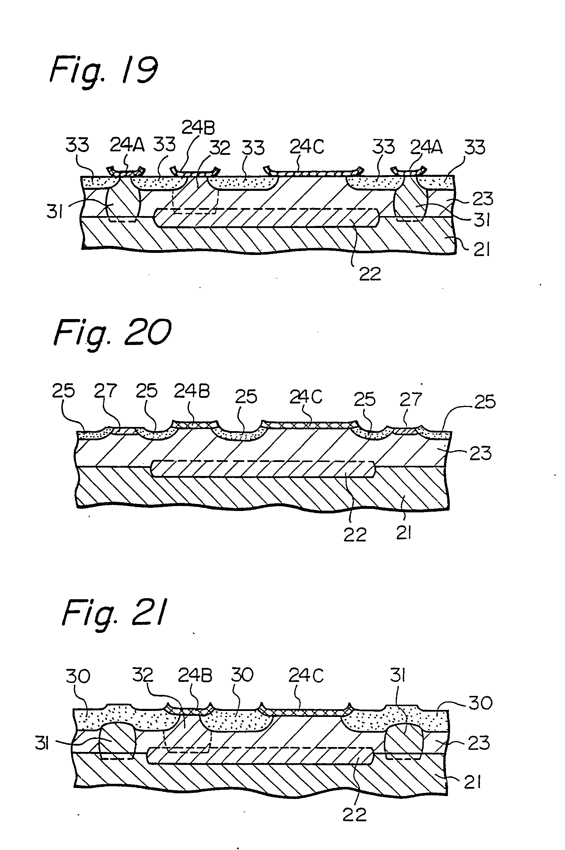

Subsequent to the step of removing the photo resist 28 (Fig. 12) of the embodiment A, the thin silicon dioxide layer 25 (Fig. 12) can be etched by an aqueous solution of hydrofluoric acid, as illustrated in Fig. 18. Then, the obtained semiconductor body is heated under the same conditions as those of the heating step of the embodiment A, so that an exposed portion of the epitaxial layer 23 is oxidised to form a thick silicon dioxide layer 33 having a thickness of approximately 1.4 μm, as illustrated in Fig. 19. At the same time, the isolation region 31 and the collector connecting region 32 are formed. Since the surfaces of the epitaxial layer 23 and the thick silicon dioxide layer 33 are almost flat, it is possible to produce a planar type bipolar transistor.

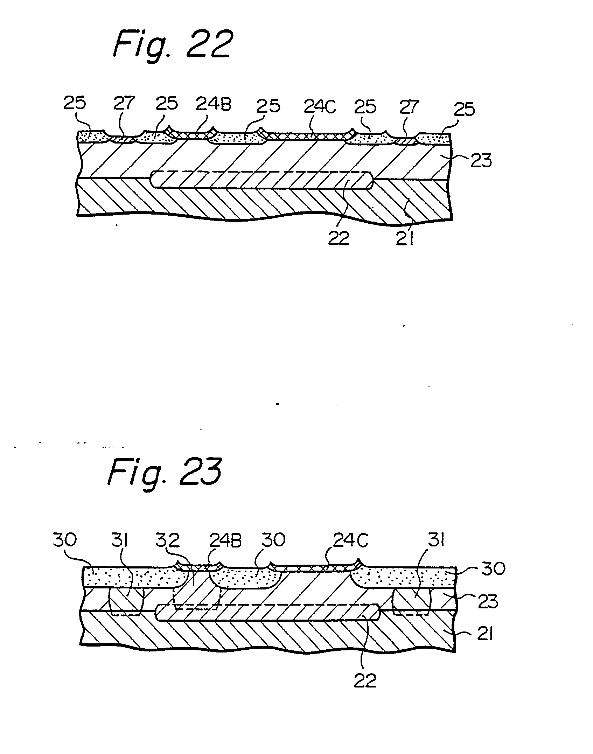

Furthermore, it is possible to combine the above-mentioned embodiments B, C and D. For example, a combination of the embodiments B and C and a combination of the embodiments C and D can be carried out. In a case where the embodiments B and C are combined, subsequent to the step of forming the high concentration region 27 and prior to step of forming the photo resist layer 28 of the embodiment A, the semiconductor body in the state illustrated in Fig. 20 is obtained. As a result, after the thermal oxidation for the thick silicon dioxide layer 30 is carried out, the semiconductor body in the state illustrated in Fig. 21 is obtained. In a case where the embodiments C and D are combined, the semiconductor body in the state illustrated in Fig. 21 is also obtained via the state illustrated in Fig. 22. The above-mentioned combinations of the embodiments can further include the step of etching a portion of the epitaxial layer corresponding to the isolation region subsequent to the step of etching the silicon nitride layer portion of the embodiment C. As a result, the semiconductor body in the state illustrated in Fig. 23 is obtained.

A second preferable embodiment according to the present invention of a method of producing a semiconductor device comprising at least one semiconductor element and an isolation region which are formed in an epitaxial layer formed on a semiconductor substrate having a buried layer comprises the steps of:

forming an anti-oxidation masking layer on the epitaxial layer;

forming an insulating layer on the anti-oxidation masking layer;

forming a patterned resist layer;

introducing the impurities into the predetermined portion of the epitaxial layer which is not under the patterned resist layer;

removing the patterned resist layer;

making a pattern mask out of the anti-oxidation masking layer, and;

selectively thermal-oxidizing the epitaxial layer to form a thick oxide layer.

The above-mentioned second embodiment will now be explained in detail by the following embodiments E through J with reference to the drawings.

*Embodiment E*

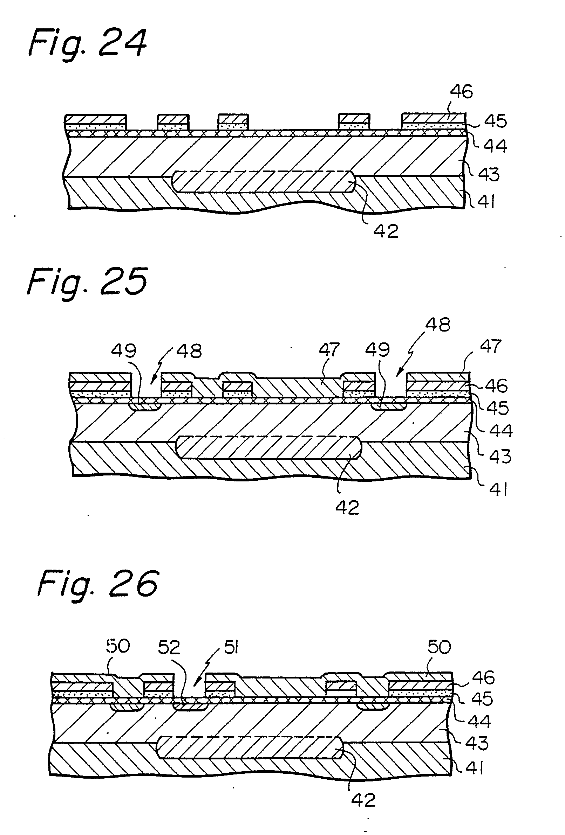

Referring to Fig. 24, the starting material is a p-type silicon semiconductor substrate 41 having an n$^+$-type buried layer 42. An n-type silicon epitaxial layer 43, having a high resistance, is formed on the silicon substrate 41 and, at the same time, some n-type impurities diffuse out of the buried layer 42 into the epitaxial layer 43, so that the buried layer 42 expands up to a broken line in Fig. 24. A silicon nitride layer 44 having a thickness of approximately 50 nm and serving as an anti-oxidation masking layer is formed on the epitaxial layer 43 by chemical vapor deposition. A silicon oxide layer (i.e. an insulating layer) 45 having a thickness of approximately 500 nm is formed on the silicon nitride layer 44 by chemical vapor deposition. Furthermore, a negative photo resist layer 46 is applied onto the silicon oxide layer 45. The negative photo resist layer 46 is exposed and developed to form a patterned negative resist layer 46. Then, using the patterned negative resist layer 46 as a mask, the silicon oxide layer 45 is selectively etched by an aqueous solution of hydrofluoric acid, as illustrated in Fig. 24.

Next, a positive photo resist layer 47 is applied onto the entire surfaces of the exposed portions of the silicon nitride layer 44 and the patterned negative resist layer 46. The positive resist layer 47 is exposed and developed to form an opening 48, as illustrated in Fig. 25. P-type impurities (e.g. boron) are introduced through a portion of the silicon nitride layer exposed within the opening 48 into the epitaxial layer 43 by ion-implantation to form a high concentration region 49 (Fig. 25) of p-type impurities.

After the positive photo resist layer 47 is removed, another positive photo resist layer 50 is applied onto the entire surfaces of the exposed portions of the silicon nitride layer 44 and the patterned negative photo resist layer 46 and, then, is exposed and developed to form another opening 51, as illustrated in Fig. 26. N-type impurities (e.g. phosphorus) are introduced through a portion of the silicon nitride layer 44 exposed within the opening 51 into the epitaxial layer 43 by ion-implantation to form a high concentration region 52 (Fig. 26) of n-type impurities.

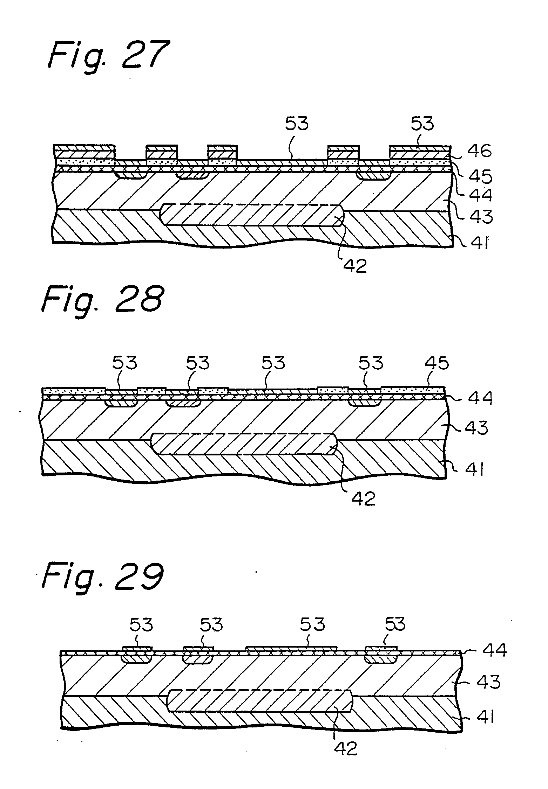

Next, the positive photo resist layer 50 is removed but the patterned negative photo resist layer 46 remains. A metal layer 53 is formed on the entire surfaces of the exposed portion of the silicon nitride layer 44 and the remaining negative photo resist layer 46 by vapor deposition, as illustrated in Fig. 27. The metal layer 53 is made of molybdenum (Mo), chromium (Cr), platinum (Pt) or polysilicon, preferably molybdenum, and has a good corrosion resistance against an etching solution of pyro-phosphoric acid for silicon nitride or of hydrofluoric acid for silicon oxide or against plasma etching.

The patterned negative photo resist layer 46 is removed by a suitable remover, and, at the same time, a portion of the metal layer 53 lying on the patterned resist layer 46 is removed, as illustrated in Fig. 28. Such removing process of a portion of the metal layer is generally a so-called lift off process.

Next, using the remaining metal layer 53 as a mask, the remaining silicon oxide layer 45 is etched by a solution of hydrofluoric acid, as illustrated in Fig. 29. It is possible to carry out a lift off process which comprises the steps of:

removing the negative photo resist layer 46 prior to the step of forming the positive photo resist layer 47;

forming a metal layer on the exposed portion of the silicon nitride layer 44 and the remaining silicon dioxide layer 45 subsequent to the impurity introducing step, and;

removing the silicon dioxide layer 45 together with a portion of the metal layer thereon.

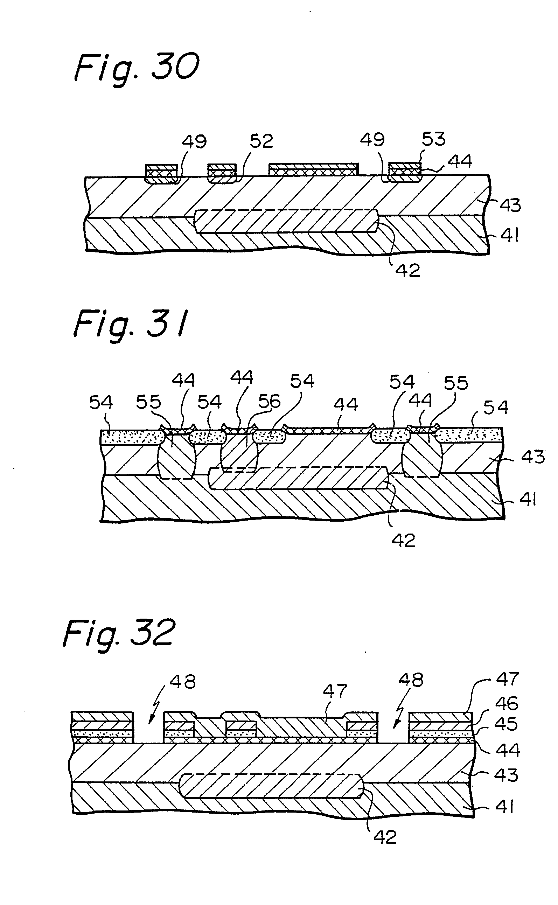

Using also the remaining metal layer 53 as a mask, a portion of the silicon nitride layer 44 is selectively etched by a solution of pyro phosphoric acid to expose a portion of the epitaxial layer 43, as illustrated in Fig. 30.

After the remaining metal layer 53 is removed by a mixed solution of nitric acid and hydrochloric acid, the obtained semiconductor body comprising the substrate 41 and the epitaxial layer 43 is heated at 1100°C, for approximately 2 hours, in an oxidizing atmosphere. As a result of the heat-treatment, i.e. a thermal oxidation treatment, the exposed portion of the epitaxial layer 43 is oxidized to form a thick silicon oxide layer 54 having a thickness of approximately 1 µm, the p-type impurities in the high concentration region 49 diffuse into the epitaxial layer 43 and arrive at the silicon substrate 41 to form an isolation region 55 and, simultaneously, the n-type impurities in the high concentration region 52 diffuse and arrive at the buried layer 42 to form a collector connecting region 56, as illustrated in Fig. 31.

Thus, since the formation of the thick silicon oxide layer, the isolation region and the collector connecting region are simultaneously carried out, the number of heat-treatments is decreased as compared with the above-mentioned prior art method of producing a semiconductor device. Therefore, the decrease in the breakdown voltage between the collector and the base caused by diffusing the n-type impurities out of the buried layer into the epitaxial layer is smaller than in the prior art.

In order to complete a bipolar transistor, a base region, an emitter region, a collector electrode, a base electrode, an emitter electrode and a required thin silicon oxide layer are formed in the same manner as in the above-mentioned prior art method.

In this embodiment, a photo etching technique (i.e. photo lithography) is used, but, an electron beam lithography, an ion beam lithography or an X-ray lithography may be used.

*Embodiment F*

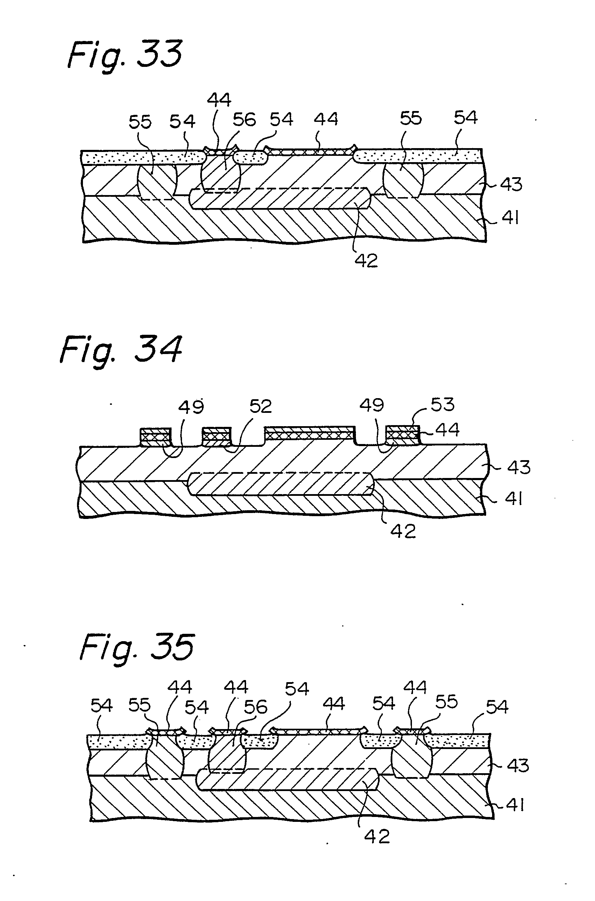

Subsequent to the step of forming the opening 48 (Fig. 25) and prior to the step of introducing the p-type impurities of the embodiment E, a portion of the silicon nitride layer 44 exposed within the opening 48 can be etched by plasma etching, as illustrated in Fig. 32. The procedure for producing a semiconductor device in this embodiment, except for the above-mentioned etching step, is the same as that of the embodiment E. As a result, the semiconductor body in the state illustrated in Fig. 33 is obtained. The thick silicon oxide layer 54 is formed on the isolation region 55, whereby the parasitic capacity between a connecting line and the isolation region can be decreased.

*Embodiment G*

Subsequent to the step of etching the portion of the silicon nitride layer 44 (refer to Fig. 30) of the embodiment E, a portion of the epitaxial layer 43 can be etched by plasma etching, as illustrated in Fig. 34. Then, the metal layer 53 is etched by the above-mentioned etchant. The obtained semiconductor body is treated in the same conditions as those of the heat-treating step of the embodiment E to obtain the semiconductor body in the state illustrated in Fig. 35. The difference between the levels of the surface of the thick silicon oxide layer 54 (Fig. 35) and the surface of the epitaxial layer 43 (Fig. 35) is smaller as compared with that of the semiconductor body in the state illustrated in Fig. 31, in the case of the embodiment E.

Furthermore, it is possible to combine the above-mentioned embodiments F and G, as the result, the semiconductor body which has a similar structure to that illustrated in Fig. 21 can be obtained. The combination of the embodiments F and G can further include the step of etching a portion of the epitaxial layer corresponding to the isolation region prior to the step of introducing p-type impurities, as the result, the semiconductor body which has a similar structure to that illustrated in Fig. 23 can be obtained.

*Embodiment H*

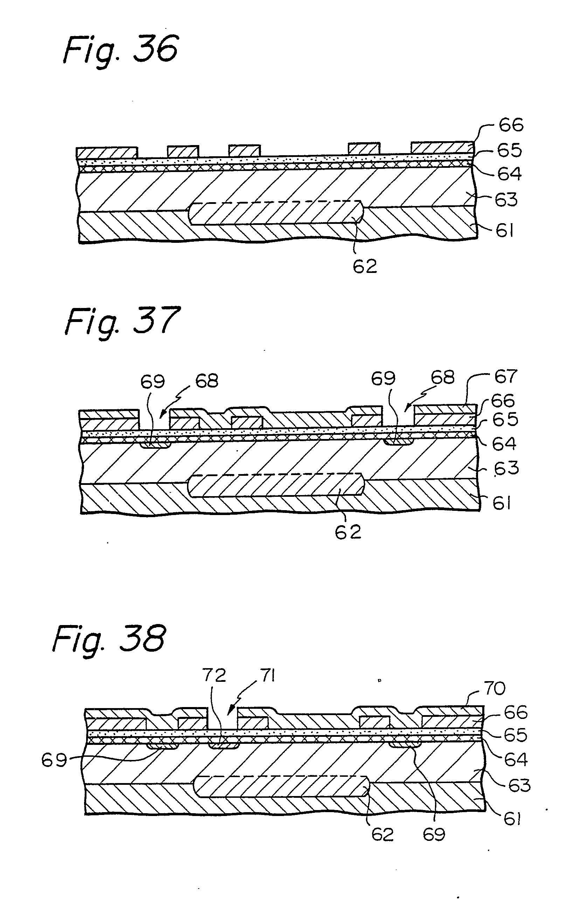

Referring to Fig. 36, the starting material is a p-type silicon semiconductor substrate 61 having an $n^+$-type buried layer 62. A n-type silicon epitaxial layer 63, having a high resistance, is formed on the silicon substrate 61 and, at the same time, some n-type impurities diffuse out of the buried layer 62 into the epitaxial layer 63, so that the buried layer 62 expands up to a broken line in Fig. 36. A silicon nitride layer 64 having a thickness of approximately 50 nm and serving as an anti-oxidation masking layer is formed on the epitaxial layer 63 by chemical vapor deposition. A silicon oxide layer (i.e. an insulating layer) 65 having a thickness of approximately 50 nm is formed on the silicon nitride layer 64 by chemical vapor deposition. Furthermore, a negative photo resist layer 66 is applied onto the silicon oxide layer 45 and, then, is exposed and developed to form a patterned negative resist layer 66, as illustrated in Fig. 36.

Next, a positive photo resist layer 67 is applied onto the entire surfaces of the exposed portions of the silicon dioxide layer 65 and the patterned negative resist layer 66. The positive resist layer 67 is exposed and developed to form an opening 68, as illustrated in Fig. 37. P-type impurities (e.g. boron) are introduced through the opening 68, through the silicon dioxide layer 65 and through the silicon nitride layer 64 into the epitaxial layer 63 by ion-implantation to form a high concentration region 69 (Fig. 37) of p-type impurities.

After the positive photo resist layer 67 is removed, another positive photo resist layer 70 is applied onto the exposed silicon dioxide layer 65 and the patterned negative resist layer 66 and, then, the positive photo resist layer 70 is exposed and developed to form another opening 71, as illustrated in Fig. 38. N-type impurities (e.g. phosphorus) are introduced through the opening 71, through the silicon dioxide layer 65 and through the silicon nitride layer 64 into the epitaxial layer 63 by ion-implantation to form a high concentration region 72 (Fig. 38) of n-type impurities.

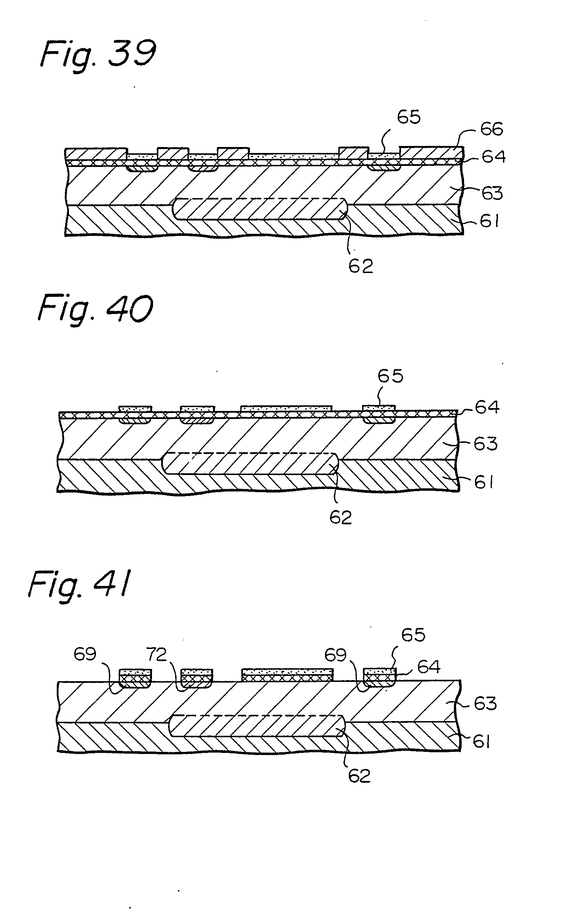

After the positive resist layer 70 is removed, the obtained semiconductor body comprising the silicon substrate 61 and the epitaxial layer 63 is placed in a reaction tube (not shown) heated at 150°C. Hydrogen fluoride (HF) gas flows through the reaction tube at the low rate of approximately 10 l/min for approximately 30 minutes. Since the hydrogen fluoride reacts with the water content of the patterned negative resist layer 66 to produce hydrofluoric acid, the hydrofluoric acid etches a portion the silicon dioxide layer 65 lying under the patterned negative resist layer 66, as illustrated in Fig. 39. Such etching process is a so-called "Dry-Ox process" (ref. Reichard L. Bersin and Reichard F. Reichelderfer, "The DryOx Process for Etching Silicon Dioxide", Solid State Technology, April (1977), pp 78—90).

Next, the negative photo resist layer 66 is removed, thus, the patterned silicon dioxide layer 65 remains, as illustrated in Fig. 40.

Using the patterned silicon dioxide layer 65 as a mask, the silicon nitride layer 64 is selectively etched by a pyro phosphoric acid solution to expose a portion of the epitaxial layer 63, as illustrated in Fig. 41.

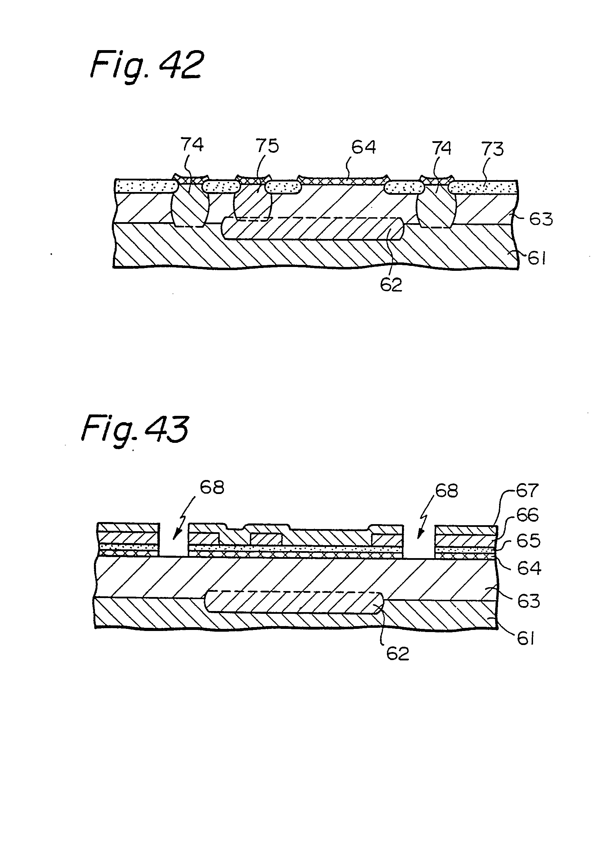

After the patterned silicon dioxide layer 65 is removed by an etchant, i.e. a solution of hydrofluoric acid, the obtained semiconductor body is heated at 1100°C, for approximately 2 hours, in an oxidizing atmosphere. As a result of this thermal oxidation treatment, the exposed epitaxial layer 63 is oxidized to form a thick silicon dioxide layer 73 having a thickness of approximately 1 µm, the p-type impurities in the high concentration region 69 diffuse into the epitaxial layer 63 and arrive at the silicon substrate 61 to form an isolation region 74 and, simultaneously, the n-type impurities in the high concentration region 72 diffuse and arrive at the buried layer 62 to form a collector connecting region 75, as illustrated in Fig. 42. The obtained semiconductor body illustrated in Fig. 42 is the same as that illustrated in Fig. 31 in the case of the embodiment E. Therefore, the merit mentioned in the embodiment E is also obtained in this embodiment H.

*Embodiment I*

Subsequent to the step of forming the opening 68 (Fig. 33) and prior to the step of introducing the p-type impurities of the embodiment H, portions of the silicon dioxide layer 65 and silicon nitride layer 64 within the opening 68 can be etched by plasma etching, as illustrated in Fig. 43. The procedure of treating steps in this embodiment, except for the above-mentioned etching step, is same as that of the embodiment H. As a result, the semiconductor body in the state illustrated in Fig. 33 can be obtained.

*Embodiment J*

Subsequent to the step of etching the silicon nitride layer 64 (refer to Fig. 41) of the embodiment H, a portion of the epitaxial layer 63 can be etched by plasma etching to obtain the semiconductor body having a structure is similar to that of the semiconductor body illustrated in Fig. 34. Then, the steps of removing the patterned silicon dioxide layer 65 and heating in the oxidizing atmosphere of the embodiment H are carried out to obtain the semiconductor body in the state illustrated in Fig. 35.

Furthermore, in a case where the length of the thick silicon dioxide portion 8C (Fig. 1), namely, the distance between the isolation region 7 and the base region 4 (Fig. 1) is 2 μm and below, the punch through phenomenon after occurs, when a depletion layer extending from the base region-epitaxial layer interface into the isolated region 2′ (Fig. 1) is joined to a depletion layer extending from the isolation region-epitaxial layer interface into the isolated region 2′. The punch through phenomenon generates an undesirable leakage current. In order to prevent the punch through phenomenon from occurring, it is preferable to introduce n-type impurities (a dose of $5 \times 10^{12}$ atoms/cm² at an energy of 60 KeV) into a portion of the epitaxial layer 2 lying under the silicon dioxide layer portion 8C by ion-implantation prior to the step of forming the thick silicon dioxide layer portion 8C.

It will be obvious that the present invention is not restricted to the above-mentioned embodiments, and that many variations are possible for those skilled in the art without departing from the scope of the present invention. For example, it is possible to produce a pnp-type bipolar transistor instead of the npn-type bipolar transistor. An anti-oxidation masking layer may be made of silicon carbide instead of silicon nitride.

**Claims**

1. A method of producing a semiconductor device comprising at least one semiconductor element and an isolation region which are formed in an epitaxial layer formed on a semiconductor substrate having a buried layer, said method comprising, the steps of forming a mask pattern for preventing impurities from entering portions of said epitaxial layer covered by the mask pattern, introducing impurities into predetermined portions of said epitaxial layer not covered by the mask pattern, forming a patterned anti-oxidation masking layer for selective thermaloxidation of the epitaxial layer, and thermally oxidizing portions of said epitaxial layer not covered by the masking layer to form a thick oxide layer at the same time said introduced impurities are diffused into said epitaxial layer to form said isolation region.

2. A method as claimed in claim 1, wherein the patterned anti-oxidation masking layer is formed by forming an anti-oxidation masking layer on said epitaxial layer and selectively removing said masking layer by photoetching to expose portions of said epitaxial layer, and wherein, after the formation of the anti-oxidation layer, and before the thermal oxidation which forms the thick oxide layer, exposed portions of the epitaxial layer are oxidised to form thin oxide layers, the mask pattern is formed by forming a patterned resist layer over the anti-oxidation mask, impurities are introduced into the predetermined portion of said epitaxial layer which is covered by said masking layer and is not under said resist layer, and said patterned resist layer is removed.

3. A method as claimed in claim 2, comprising the step of etching said exposed portions of the epitaxial layer prior to formation of the thin oxide layers.

4. A method as claimed in claim 2 or 3, comprising the step of removing a portion of said masking layer which is not covered by said patterned resist layer by etching subsequent to formation of the patterned resist layer.

5. A method as claimed in claim 2, 3 or 4, comprising the step of removing said thin oxide layer prior to formation of the thick oxide layer.

6. A method as claimed in claim 1, wherein the patterned anti-oxidation masking layer is formed by forming an anti-oxidation layer on said epitaxial layer and subsequently selectively removing portions of the anti-oxidation layer, and wherein, prior to the selective removal of portions of the anti-oxidation layer, an insulating layer is formed on said anti-oxidation layer, a patterned resist layer is formed on the insulating layer to define said mask pattern, and the patterned resist layer is removed after the introduction of the said impurities into the epitaxial layer which is not under said resist layer.

7. A method as claimed in claim 6, wherein the formation and removal of the said patterned resist layer comprises the steps of forming a patterned negative resist layer on said insulating layer, selectively etching said insulating layer using said negative resist layer as a mask, forming a patterned positive resist layer on said negative resist layer and portions of said anti-oxidation masking layer, the second impurities being introduced into the predetermined portion of said epitaxial layer which is not covered by said positive resist layer, removing said patterned positive resist layer, a metal layer being formed over all of the surfaces of said patterned negative resist layer and said anti-oxidation masking layer exposed by the removal of the positive resist layer, and removing said negative resist layer and the portion of said metal layer lying thereon, the remaining insulating layer and the portion of said anti-oxidation layer lying thereunder being etched thereby effecting said selective removal of portions of the anti-oxidation layer, and the remaining metal layer being removed before said thermal oxidation of said epitaxial layer.

8. A method as claimed in claim 6, wherein the formation and removal of the said patterned resist layer comprises the steps of forming a patterned negative resist layer on said insulating layer, selectively etching said insulating layer using said negative resist layer as a mask, removing said patterned negative resist layer, forming a patterned positive resist layer on said insulating layer and portions of said anti-oxidation masking layer, the said impurities being introduced into the predetermined portion of said epitaxial layer which is not covered by said positive resist layer, removing said patterned positive resist layer, a metal layer being formed over all of the surface of said insulating layer and said anti-oxidation masking layer exposed by removal of the positive resist layer, and removing said insulating layer and the portion of said metal layer lying thereon, the portion of said anti-oxidation layer exposed by removal of the insulating layer being etched using the remaining metal layer as a mask thereby effecting said selective removal of portions of the anti-oxidation layer, and the remaining metal layer being removed before said thermal oxidation of said epitaxial layer.

9. A method as claimed in claim 7 or 8, wherein prior to the introduction of the impurities into the epitaxial layer the portion of said anti-oxidation layer which lies on said predetermined portions of the epitaxial layer is removed.

10. A method as claimed in claim 7, 8 or 9, wherein a portion of said epitaxial layer is etched prior to the removal of the remaining metal layer.

11. A method as claimed in claim 6, wherein the formation of the patterned resist layer comprises the steps of forming a patterned negative resist layer on said insulating layer, and forming a patterned positive resist layer on said negative resist layer and portions of said insulating layer, and wherein the formation of the said anti-oxidation masking layer comprises the steps of etching the portion of said insulating layer which is covered with said patterned negative resist layer by using a reaction between the water content in said negative resist and hydrogen fluoride gas, removing said negative resist layer, etching said anti-oxidation layer by using the remaining insulating layer as a mask, and removing said remaining insulating layer.

12. A method as claimed in claim 11 further comprising the step of etching a portion of said epitaxial layer subsequent to the removal of the remaining insulating layer.

13. A method as claimed in claim 11 or 12, wherein the steps of etching portions of said insulating layer and said anti-oxidation masking layer are performed subsequent to the step of forming the patterned positive resist layer.

14. A method as claimed in any preceding claim, wherein the conductivity type of said introduced impurities for the isolation region is the same as that of said semiconductor substrate.

**Revendications**

1. Procédé de fabrication d'un dispositif semiconducteur comprenant au moins un élément semiconducteur et une région d'isolement qui sont formés dans une couche épitaxiale formée sur un substrat semiconducteur muni d'une couche enterrée, ce procédé comprenant les étapes consistant à former un motif de masque pour empêcher des impuretés d'entrer dans des parties de la couche épitaxiale recouvertes du motif de masque, introduire des impuretés dans des parties prédéterminées de la couche épitaxiale non recouvertes du motif de masque, former une couche de masquage anti-oxydation de configuration déterminée pour une oxydation thermique sélective de la couche épitaxiale, et oxyder thermiquement des parties de la couche épitaxiale non recouvertes de la couche de masquage pour former une couche d'oxyde épais en même temps que les impuretés introduites sont diffusées dans la couche épitaxiale pour former la région d'isolement.

2. Procédé selon la revendication 1, dans lequel la couche de masquage anti-oxydation ayant une configuration déterminée est formée par formation d'une couche de masquage anti-oxydation sur la couche épitaxiale et enlèvement sélectif de la couche de masquage par photogravure pour exposer des parties de la couche épitaxiale, et dans lequel, après formation de la couche anti-oxydation, et avant l'oxydation thermique qui forme la couche d'oxyde épais, des parties exposées de la couche épitaxiale sont oxydées pour former des couches d'oxyde mince, le motif de masque est formé par formation d'une couche de produit photosensible ayant une configuration déterminée sur le masque anti-oxydation, des impuretés sont introduites dans la partie prédéterminée de la couche épitaxiale qui est recouverte de la couche de masquage et ne se trouve pas sous la couche de produit photosensible, et la couche de produit photosensible ayant une configuration prédéterminée est enlevée.

3. Procédé selon la revendication 2, comprenant l'étape d'attaque des parties exposées de la couche épitaxiale avant formation des couches d'oxyde mince.

4. Procédé selon l'une des revendications 2 ou 3, comprenant l'étape d'enlèvement d'une partie de la couche de masquage non recouverte de la couche de produit photosensible ayant une configuration déterminée par une attaque ultérieure à la formation de la couche de produit photosensible ayant une configuration déterminée.

5. Procédé selon l'une quelconque des revendications 2, 3 ou 4, comprenant l'étape d'enlèvement de la couche d'oxyde mince avant la formation de la couche d'oxyde épais.

6. Procédé selon la revendication 1, dans lequel la couche de masquage anti-oxydation ayant une configuration déterminée est formée par formation d'une couche anti-oxydation sur la couche épitaxiale et enlèvement sélectif ultérieur de parties de la couche anti-oxydation, et dans lequel, ayant l'enlèvement sélectif des parties de la couche anti-oxydation, une couche isolante est formée sur la couche anti-oxydation, une couche de produit photosensible ayant une configuration déterminée est formée sur la couche isolante pour définir le motif de masque, et, la couche de produit photosensible de configuration déterminée est enlevée après introduction des impuretés dans la couche épitaxiale qui n'est pas sous la couche de produit photosensible.

7. Procédé selon la revendication 6, dans lequel la formation et l'enlèvement de la couche de produit photosensible ayant une configuration déterminée comprend les étapes consistant à former une couche de produit photosensible négatif de configuration déterminée dans la couche isolante, à attaquer sélectivement la couche isolante en utilisant la couche de produit photosensible négatif comme masque, à former une couche de produit photosensible positif ayant une configuration déterminée sur la couche de produit photosensible négatif et des parties de la couche de masquage anti-oxydation, lesdites impuretés étant introduites dans la partie prédéterminée de la couche épitaxiale qui n'est pas couverte de la couche de produit photosensible positif, à enlever la couche de produit photosensible positif ayant une configuration déterminé, une couche de métal étant formée sur toutes les surfaces de la couche de produit photosensible négatif ayant une configuration déterminée et la couche de masquage anti-oxydation exposée par enlèvement de la couche de produit photosensible positif, et à enlever la couche de produit photosensible négatif et la partie de la couche métallique se trouvant sur celle-ci, la couche isolante restante, et la partie de la couche anti-oxydation sous-jacente étant attaquées, effectuant ainsi l'enlèvement sélectif des parties de la couche anti-oxydation, et la couche métallique restante étant enlevée avant l'oxydation thermique de la couche épitaxiale.

8. Procédé selon la revendication 6, dans lequel la formation et l'enlèvement de la couche de produit photosensible ayant une configuration déterminée comprennent des étapes consistant à former une couche de produit photosensible négatif de configuration déterminée sur la couche isolante, à attaquer sélectivement la couche isolante en utilisant la couche de produit photosensible négatif comme masque, à enlever la couche de produit photosensible négatif de configuration déterminée, à former une couche de produit photosensible positif de configuration déterminée sur la couche isolante et des parties de la couche de masquage anti-oxydation, lesdits impuretés étant introduites dans la partie prédéterminée de la couche épitaxiale qui n'est pas couverte de la couche de produit photosensible positif, à enlever la couche de produit photosensible positif de configuration déterminée, une couche métallique étant formée sur toute la surface de la couche isolante et de la couche de masquage anti-oxydation exposée par enlèvement de la couche de produit photosensible positif, et à enlever la couche isolante et la partie de la couche métallique se trouvant au-dessus, la partie de la couche anti-oxydation exposée par enlèvement de la couche isolante étant attaquée en utilisant la couche métallique restante comme masque, effectuant ainsi l'enlèvement sélectif des parties de la couche anti-oxydation, et la couche métallique restante étant enlevée ayant l'oxydation thermique de la couche épitaxiale.

9. Procédé selon l'une des revendications 7 ou 8, dans lequel, avant l'introduction des impuretés dans la couche épitaxiale, la partie de la couche anti-oxydation qui se trouve sur les parties prédéterminées de la couche épitaxiale est enlevée.

10. Procédé selon l'une des revendications 7, 8 ou 9, dans lequel une partie de la couche épitaxiale est attaquée avant enlèvement de la couche de métal restante.

11. Procédé selon la revendication 6, dans lequel la formation de la couche de produit photosensible ayant une configuration déterminée comprend les étapes consistant à former une couche de produit photosensible négatif de configuration déterminée sur la couche isolante, et à former une couche de produit photosensible positif de configuration déterminée sur la couche de produit photosensible négatif et des parties de la couche isolante, et dans lequel la formation de la couche de masquage anti-oxydation comprend les étapes consistant à attaquer la partie de la couche isolante qui est recouverte de la couche de produit photosensible de configuration déterminée en utilisant une réaction entre le contenu en eau du produit photosensible négatif et du fluorure d'hydrogène gazeux, à enlever la couche de produit photosensible négatif, à attaquer la couche anti-oxydation en utilisant la couche isolante restante comme masque, et à enlever la couche isolante restante.

12. Procédé selon la revendication 11 comprenant en outre l'étape consistant à attaquer une partie de la couche épitaxiale après enlèvement de la couche isolante restante.

13. Procédé selon l'une des revendications 11 ou 12, dans lequel les étapes d'attaque de parties de la couche isolante et de la couche de masquage anti-oxydation sont réalisées après l'étape de formation de la couche de produit photosensible positif de configuration déterminée.

14. Procédé selon l'une quelconque des revendications précédentes, dans lequel le type de conductivité des impuretés introduites pour la région d'isolement est le même que celui du substrat semiconducteur.

**Patentansprüche**

1. Verfahren zur Herstellung einer Halbleitervorrichtung mit wenigstens einem Halbleiterelement und einem Isolationsbereich, welche in einer epitaktischen Schicht gebildet sind, die auf einem Halbleitersubstrat gebildet ist, das eine vergrabene Schicht enthält, mit den folgenden Schritten:
Bildung eines Maskenmusters zur Verhinderung des Eindringens von Verunreinigungen in Abschnitte der genannten epitaktischen Schicht, welche durch das Maskenmuster bedeckt ist, Einführung von Verunreinigungen in vorbestimmte Abschnitte der genannten epitaktischen Schicht, die nicht durch das Maskenmuster bedeckt sind, Bildung einer gemusterten Antioxidations-Maskierungsschicht für die selektive Thermaloxidation der epitaktischen Schicht, und Thermaloxidierung von Abschnitten der genannten epitaktischen Schicht, die nicht durch die Maskierungsschicht bedeckt ist, um eine dicke Oxidschicht zu bilden, während zur selben Zeit die genannten eingeführten Verunreinigungen in die genannte epitaktische Schicht diffundiert werden, um den genannten Isolationsbereich zu bilden.

2. Verfahren nach Anspruch 1, bei welchem die gemus terte Antioxidations-Maskierungsschicht durch Bildung einer Antioxidations-Maskierungsschicht auf der genannten epitaktischen Schicht und durch selektive Entfernung der genannten Maskierungsschicht durch Photoätzung gebildet wird, um Abschnitte der genannten epitaktischen Schicht zu exponieren, und bei welchem, nach der Bildung der Antioxidationsschicht, und vor der Thermaloxidation, welche die dicke Oxidschicht bildet, exponierter Abschnitte der epitaktischen Schicht oxidiert werden, um dünne Oxidschichten zu bilden, das Maskenmuster durch Bildung einer gemusterten Resistschicht über der Antioxidationsmaske gebildet wird, Verunreinigungen in den vorbestimmten Abschnitt der genannten epitaktischen Schicht eingefügt werden, welche durch die genannte Maskierungsschicht bedeckt ist und sich nicht unter der genannten Resistschicht befindet, und die genannte gemusterte Resistschicht entfernt wird.

3. Verfahren nach Anspruch 2, bei welchem der Schritt der Ätzung der genannten exponierten Abschnitte der epitaktischen Schicht vor der Bildung der dünnen Oxidschichten durchgeführt wird.

4. Verfahren nach Anspruch 2 oder 3, mit dem Schritt der Entfernung eines Abschnitts der genannten Maskierungsschicht, welcher nicht durch die genannte gemusterte Resistschicht bedeckt ist, durch Ätzen, nach der Bildung der gemusterten Resistschicht.

5. Verfahren nach Anspruch 2, 3 oder 4, mit dem Schritt der Entfernung der genannten dünnen Oxidschicht vor der Bildung der dicken Oxidschicht.

6. Verfahren nach Anspruch 1, bei welchem die gemusterte Antioxidations-Maskierungsschicht durch Bildung einer Antioxidationsschicht auf der genannten epitaktischen Schicht und durch folgende selektive Entfernung von Abschnitten der Antioxidationsschicht gebildet wird, und bei welchem, vor der selektiven Entfernung von Abschnitten der Antioxidationsschicht, eine isolierende Schicht auf der genannten Oxidationsschicht gebildet wird, eine gemusterte Resistschicht auf der isolierenden Schicht gebildet wird, um das genannte Maskenmuster zu definieren, und die gemusterte Resistschicht nach Einführung der genannten Verunreinigungen in die epitaktische Schicht, welche nicht unterhalb der genannten Resistschicht ist, entfernt wird.

7. Verfahren nach Anspruch 6, bei welchem die Bildung und die Entfernung der genannten gemusterten Resistschicht die folgenden Schritte umfaßt:
Bildung einer gemusterten negativen Resistschicht auf der genannten isolierenden Schicht, selektive Ätzung der genannten isolierenden Schicht unter Verwendung der genannten negativen Resistschicht als Maske, Bildung einer gemusterten positiven Resistschicht auf der genannten negativen Resistschicht und Abschnitten der genannten Antioxidations-Maskierungsschicht, wobei die genannten Verunreinigungen in vorbestimmte Abschnitte der genannten epitaktischen Schicht eingeführt werden, welche nicht durch die genannte positive Resistschicht bedeckt ist, Entfernung der genannten gemusterten positiven Resistschicht, Bildung einer Metallschicht über allen Oberflächen der genannten gemusterten Resistschicht und der genannten Antioxidations-Maskierungsschicht, die durch Entfernung der positiven Resistschicht exponiert ist, und Entfernung der genannten negativen Resistschicht und des Abschnitts der genannten Metallschicht, der darauf liegt, wobei die verbleibende isolierende Schicht und der Abschnitt der Antioxidationsschicht, welcher darunter liegt, geätzt werden, wodurch die genannte selektive Entfernung von Abschnitten der Antioxidationsschicht bewirkt wird, und Entfernung der verbleibenden Metallschicht vor der genannten thermischen Oxidation der genannten epitaktischen Schicht.

8. Verfahren nach Anspruch 6, bei welchem die Bildung und die Entfernung der genannten gemusterten Resistschicht die Schritte umfaßt:
Bildung einer gemusterten negativen Resistschicht auf der genannten isolierenden Schicht, selektive Ätzung der genannten isolierenden Schicht, unter Verwendung der genannten negativen Resistschicht als Maske, Entfernung der genannten gemusterten negativen Resistschicht, Bildung einer gemusterten positiven Resistschicht auf der genannten isolierenden Schicht und Abschnitten der genannten Antioxidations-Maskierungsschicht,

wobei die genannten Verunreinigungen in den vorbestimmten Abschnitt der genannten epitaktischen Schicht eingeführt werden, welcher nicht durch die genannte positive Resistschicht bedeckt ist, Entfernung der genannten gemusterten positiven Resistschicht, Bildung einer Metallschicht über allen Oberflächen der genannten isolierenden Schicht und der genannten Antioxidations-Maskierungsschicht, die durch Entfernung der positiven Resistschicht exponiert ist, und Entfernung der genannten isolierenden Schicht und des Abschnitts der genannten Metallschicht, welcher darunter liegt, wobei der Abschnitt der genannten Antioxidationsschicht, der durch Entfernung der isolierenden Schicht exponiert ist, geätzt wird, unter Verwendung der verbleibenden Metallschicht als Maske, um dadurch die genannte selektive Entfernung von Abschnitten der Antioxidationsschicht zu bilden,

und bei welchem die verbleibende Metallschicht vor der thermischen Oxidation der genannten epitaktischen Schicht entfernt wird.

9. Verfahren nach Anspruch 7 oder 8, bei welchem vor Einführung der Verunreinigungen in die epitaktische Schicht der Abschnitt der genannten Antioxidationsschicht, welcher auf den genannten vorbestimmten Abschnitten der epitaktischen Schicht liegt, entfernt wird.

10. Verfahren nach Anspruch 7, 8 oder 9, bei welchem ein Abschnitt der genannten epitaktischen Schicht vor der Entfernung der verbleibenden Metallschicht geätzt wird.

11. Verfahren nach Anspruch 6, bei welchem die Bildung der gemusterten Resistschicht die Schritte der Bildung einer gemusterten negativen Resistschicht auf der genannten isolierenden Schicht und die Bildung einer gemusterten positiven Resistschicht auf der genannten negativen Resistschicht und Abschnitten der genannten isolierenden Schicht umfaßt, und bei welchem die Bildung der genannten Antioxidations-Maskierungsschicht die Schritte der Ätzung des Abschnitts der genannten isolierenden Schicht, welcher mit der genannten gemusterten negativen Resistschicht bedeckt ist, unter Verwendung einer Reaktion zwischen dem Wassergehalt in dem genannten negativen Resist und Fluorwasserstoffgas, die Entfernung der genannten negativen Resistschicht, und die Ätzung der genannten Antioxidationsschicht durch Verwendung der verbleibenden isolierenden Schicht als eine Maske, und die Entfernung der verbleibenden isolierenden Schicht umfaßt.

12. Verfahren nach Anspruch 11, mit dem Schritt der Ätzung eines Abschnitts der genannten epitaktischen Schicht nach der Entfernung der verbleibenden isolierenden Schicht.

13. Verfahren nach Anspruch 11 oder 12, bei welchem die Schritte der Ätzung von Abschnitten der genannten isolierenden Schicht und der genannten Antioxidations-Maskierungsschicht nach dem Schritt der Bildung der gemusterten Positiven Resistschicht durchgeführt werden.

14. Verfahren nach einem der vorhergehenden Ansprüche, bei welchem der Leitfähigkeitstyp der genannten eingeführten Verunreinigungen für den Isolationsbereich derselbe wie derjenige des genannten Halbleitersubstrats ist.

*Fig. 1*

*Fig. 2*

*Fig. 3*

*Fig. 4*

*Fig. 5*

*Fig. 6*

*Fig. 7*

*Fig. 8*

*Fig. 9*

*Fig. 10*

*Fig. 11*

*Fig. 12*

*Fig. 13*

*Fig. 14*

*Fig. 15*

0 020 144

## Fig. 16

## Fig. 17

## Fig. 18

6

*Fig. 19*

33  24A  33  24B  32  33  24C  33  24A  33

31

23
31
21

22

*Fig. 20*

25  27  25  24B  25  24C  25  27  25

23

22  21

*Fig. 21*

30  32  24B  30  24C  31

30

31

23

21

22

## Fig. 22

## Fig. 23

## Fig. 24

46
45
44
43
41
42

## Fig. 25

49  48  47  49  48  47
46
45
44
43
41
42

## Fig. 26

50  52  51  50
46
45
44
43
41
42

## Fig. 27

## Fig. 28

## Fig. 29

*Fig. 30*

*Fig. 31*

*Fig. 32*

## Fig. 33

## Fig. 34

## Fig. 35

## Fig. 36

66
65
64
63
61

62

## Fig. 37

69  68          69   68   67
                          66
                          65
                          64
                          63
                          61

62

## Fig. 38

72   71          70
              66
              65
69            64
              63
              61

62   69

*Fig. 39*

*Fig. 40*

*Fig. 41*

## Fig. 42

## Fig. 43